## Europäisches Patentamt
## European Patent Office
## Office européen des brevets

(19)

(11) Veröffentlichungsnummer: **0 121 910**
**B1**

# EUROPÄISCHE PATENTSCHRIFT

(12)

(45) Veröffentlichungstag der Patentschrift:
01.07.87

(21) Anmeldenummer: 84103801.1

(22) Anmeldetag: 05.04.84

(51) Int. Cl.⁴: **B 23 K 1/00,** B 23 K 3/00,
H 05 K 3/34

(54) Entlötgerät.

(30) Priorität: 07.04.83 DE 8310164 U

(43) Veröffentlichungstag der Anmeldung:
17.10.84 Patentblatt 84/42

(45) Bekanntmachung des Hinweises auf die Patenterteilung:
01.07.87 Patentblatt 87/27

(84) Benannte Vertragsstaaten:
AT BE CH DE FR GB IT LI LU NL SE

(56) Entgegenhaltungen:
DE-A-2 453 022
DE-A-2 529 554

(73) Patentinhaber: **Cooper Industries Inc., P.O. Box 4446, Houston Texas 77210 (US)**

(72) Erfinder: **Munz, Volker, Besigheimer Strasse 65, D-7125 Kirchheim (DE)**
Erfinder: **Goerlich, Peter, Gutenbergstrasse 6, D-7122 Besigheim (DE)**

(74) Vertreter: **Feldkamp, Rainer, Dipl.- Ing., Patent Attorneys Dipl.- Ing. Curt Wallach Dipl.- Ing. Günther Koch, Dr. Tino Haibach Dipl.- Ing. Rainer Feldkamp Kaufinger Strasse 8, D-8000 München 2 (DE)**

## Beschreibung

Die Erfindung bezieht sich auf ein Entlötgerät für elektronische Bauteile, deren Anschlüsse flach auf einer Trägerplatte aufgelötet sind, mit einem Heizstempel, der durch ein Heizelement beheizt ist, und mit Vakuumabsaugeinrichtungen zum Ansaugen des elektronischen Bauteils an den Heizstempel.

Es ist eine Vielzahl von Entlötgeräten zum Entlöten elektronischer Bauteile bekannt, die dazu dienen, die Anschlüsse der elektronischen Bauteile soweit zu erwärmen, daß das diese Anschlüsse mit einer Trägerplatte verbindende Lot schmilzt, so daß das Bauteil entfernt werden kann. In vielen Fällen sind derartige Lötgeräte mit Vakuumabsaugeinrichtungen verbunden, die ein Absaugen des Lotes ermöglichen. Das Absaugen des Lotes ist jedoch bei elektronischen Bauteilen, deren Anschlüsse flach auf eine Trägerplatte aufgelötet sind, nur sehr schwierig durchzuführen, da sich das Lot unterhalb der einzelnen Anschlüsse und zwischen diesen und der Trägerplatte, beispielsweise einer gedruckten Schaltungsplatte befindet. Wenn ein derartiges elektronisches Bauteil lediglich erwärmt wird, muß das Abheben des Bauteils von der Trägerplatte sehr schnell erfolgen, und zwar bevor das Lot wieder erkaltet ist. Andererseits ist es erwünscht, den Anschlüssen des Bauteils eine möglichst geringe Wärmemenge zuzuführen, um eine thermische Schädigung des elektronischen Bauteils zu verhindern, so daß die Abkühlung sehr schnell erfolgt.

Es ist ein Entlötgerät der eingangs genannten Art bekannt (DE-AI-25 29 554) bei dem das untere Ende der Aussparung des Heizstempels durch ein Saugsieb verbunden ist, wobei die Aussparung mit einem Vakuumstutzen in Verbindung steht, der durch das Saugsieb hindurch Umgebungsluft durch die Aussparung hindurch absaugt. Hierdurch ergibt sich eine ungenau kontrollierbare Wärmeabfuhr von dem Saugsieb aufgrund der Absaugwirkung, was umso kritischer ist, als die Unterseite des Saugsiebes mit der Oberfläche des zu entlötenden elektronischen Bauteils in Eingriff gebracht wird und die Wärmeübertragung zu den Lötstellen durch das elektronische Bauteil hindurch erfolgt. Weiterhin erfolgt die Wärmeübertragung von dem Heizelement auf den Heizstempel über ein auf den Saugstutzen aufgeklemmtes Heizelement, so daß auch hier ein unkontrollierbarer Wärmeübergang entsteht. Damit ist die Temperatur des Heizstempels nur sehr ungenau steuerbar und durch die Wärmeübertragung durch das elektronische Bauteil hindurch besteht eine erhebliche Gefahr einer Beschädigung dieses elektronischen Bauteils.

Der Erfindung liegt die Aufgabe zugrunde, ein Entlötgerät der eingangs genannten Art zu schaffen, das eine sehr einfache und sichere Entfernung elektronischer Bauteile mit flachen Anschlüssen ermöglicht.

Diese Aufgabe wird ausgehend von einem Entlötgerät der eingangs genannten Art durch die im kennzeichnenden Teil des Anspruch 1 angegebenen Merkmale gelöst.

Vorteilhafte Ausgestaltungen und Weiterbildungen der Erfindung ergeben sich aus den Unteransprüchen.

Durch die erfindungsgemäße Ausgestaltung des Entlötgerätes wird ein leichtes und wirkungsvolles Entfernen elektronischer Bauteile, deren Anschlüsse flach auf einer Trägerplatte aufgelötet sind, ermöglicht, da diese von dem Saugnapf angesaugt und von der Trägerplatte abgehoben werden, wobei lediglich die Anschlüsse des Bauteils mit den unteren Kanten des Heizstempels in Berührung kommen. Die durch den Saugnapf hindurch vor dem Aufsetzen auf das elektronische Bauteil abgesaugte Luft führt hierbei allenfalls zu einer Abkühlung des Innenraumes der Aussparung, beeinflußt die Temperatur der unteren Kanten des Heizstempels jedoch nur wenig, so daß die Wärme gezielt an die zu entlötenden Stellen zugeführt wird, während das elektronische Bauteil in dem Hohlraum geschützt aufgenommen wird.

Durch die Befestigung des Heizstempels über eine Schraubverbindung mit Dichtungsflächen ergibt sich ein guter Wärmeübergang vom Heizelement zum Heizstempel bei gleichzeitiger Abdichtung der Verbindung, so daß das Vakuum über diese Verbindung zwischen dem Heizstempel und dem Heizelement aufrechterhalten werden kann.

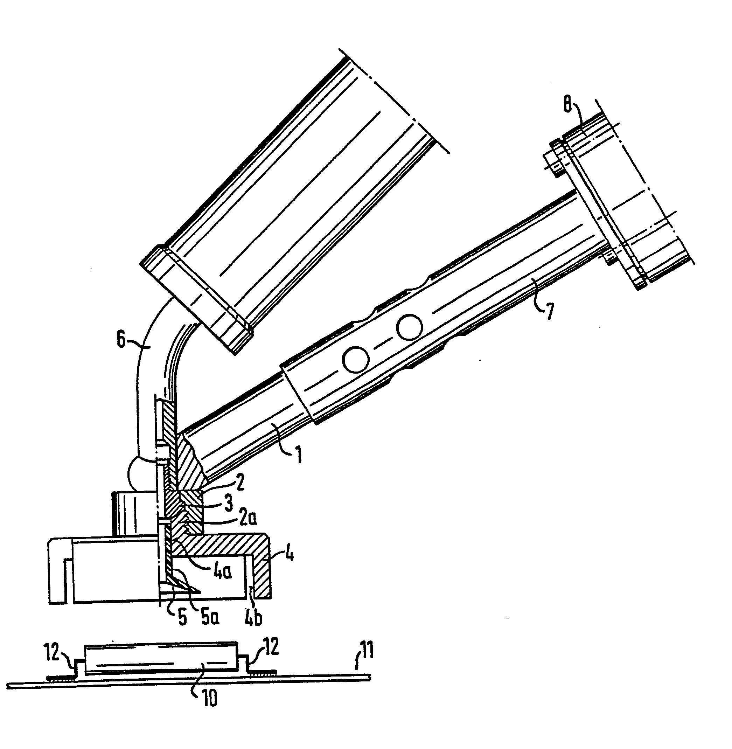

Ein Ausführungsbeispiel der Erfindung wird im folgenden anhand der Zeichnung noch näher erläutert.

In der Zeichnung ist eine Ausführungsform des Entlötgerätes vor dem Aufsetzen auf ein elektronisches Bauteil... dargestellt.

Die Ausführungsform des Entlötgerätes weist einen üblichen Lötkolben-Handgriff 8 mit einem daran befestigten, das Heizelement 1 tragenden Schaft 7 auf. Dieses Heizelement 1 ist über Befestigungsmittel mit einem Heizstempel 4 verbunden, der eine Aussparung 4b aufweist, in die das zu entlötende elektronische Bauteil 10 paßt. Dieses elektronische Bauteil 10 st über Anschlüsse 12 mit einer Leiterplatte 11 verlötet.

In der Aussparung 4b des Heizstempels 4 ist ein Saugnapf 5 angeordnet, der einen Rohransatz 5a aufweist, der in eine Bohrung 4a des Heizstempels eingesetzt ist, der sich durch den Heizstempel und einen an dessen Oberseite angeordneten Gewindestutzen 2a erstreckt. Dieser Gewindestutzen 2a weist eine konische Dichtungsfläche auf, die mit einer entsprechend komplementären Dichtungsfläche eines Schraubnippels 3 zusammenwirkt, der in eine Gewindebohrung des Heizelementes 1 eingeschraubt ist. Der Schraubnippel 3 weist ebenfalls eine durchgehende, eine Verlängerung der Bohrung in dem Gewindestutzen 2a darstellende Bohrung auf, die schließlich in einen Vakuumabsaugschlauch 6 der Vakuumabsaugeinrichtungen mündet.

2

Über den Schraubnippel 3 greift eine Überwurfmutter 2, die mit dem Gewinde des Gewindestutzens 2a des Heizstempels in Gewindeeingriff steht, so daß die beiden Dichtungsflächen an dem Schraubnippel und dem Gewindestutzen in feste Anlage aneinander vorgespannt werden können. Hierdurch ergibt sich eine gute Wärmeübertragung zwischen dem Heizelement und dem Heizstempel, sowie gleichzeitig eine vakuumdichte Abdichtung zwischen dem Gewindestutzen und dem Schraubnippel.

Weiterhin ist eine Einstellung der Lage des Heizstempels gegenüber dem Handgriff 8 möglich, so daß eine bequeme Handhabung möglich ist.

Der Saugnapf 5 besteht entweder aus Gummi oder aus wärmebeständigem Kunststoff und er kann entweder einstückig mit dem Rohransatz 5a oder von diesem getrennt ausgebildet sein. Der Rohransatz 5a ist in der Bohrung des Heizstempels verschiebbar befestigt, so daß eine Einstellung seiner Höhenlage in der Aussparung an die Höhe des elektronischen Bauteils 10 möglich ist, um zu vermeiden, daß das elektronische Bauteil durch die Elastizität des Saugnapfes aus dem Hohlraum herausgedrückt wird, bevor der eigentliche Abhebevorgang erfolgt.

Zum Entlöten des elektronischen Bauteils 10 wird der Heizstempel mit seinen unteren Kanten auf die Anschlüsse 12 des elektronischen Bauteils aufgesetzt, wobei der Saugnapf 5 mit der Oberfläche dieses elektronischen Bauteils in Eingriff kommt. Bei Betätigung der Vakuumabsaugeinrichtungen wird der Saugnapf an das elektronische Bauteil angesaugt und nach dem Erwärmen der Anschlüsse 12 kann das elektronische Bauteil durch Abheben des Heizstempels mit abgehoben werden. Durch Unterbrechung der Vakuumabsaugung kann das elektronische Bauteil dann aus der Aussparung 4 entfernt werden.

Die unteren Randkanten des Heizstempels 4 können je nach Art des elektronischen Bauteiles entweder durch Lot benetzbar oder nicht benetzbar ausgebildet sein. Bei einer benetzbaren Ausgestaltung des Heizstempels ergibt sich zwar eine bessere Wärmeübertragung, doch kann dies bei sehr nahe beieinanderliegenden Anschlüssen 12 des elektronischen Bauteils zur Brückenbildung zwischen den einzelnen Leiterbahnen auf der Leiterplatte 11 führen, so daß es insbesondere bei sehr kleinen elektronischen Bauteilen vorzuziehen sein kann, den Heizstempel durch Lot nicht benetzbar auszuführen.

**Patentansprüche**

1. Entlötgerät für elektronische Bauteile (10), deren anschlüsse flach auf einer Trägerplatte (11) aufgelötet sind, mit einen Heizstempel (4), der durch ein Heizelement beheizt ist und eine Aussparung aufweist, und mit Vakuumabsaugeinrichtungen zum Ansaugen des elektronischen Bauteils (10) an den Heizstempel, dadurch gekennzeichnet, daß die Vakuumabsaugeinrichtungen (6) mindestens einen Saugnapf (5) einschließen, der in der Aussparung (4b) angeordnet ist und in der Betriebsstellung des Entlötgerätes mit der freiliegenden Oberfläche des elektronischen Bauteils (10) in Eingriff steht, während die unteren Kanten des Heizstempels (4) auf die Anschlüsse (12) des elektronischen Bauteils (10) aufgesetzt sind.

2. Entlötgerät nach Anspruch 1, dadurch gekennzeichnet, daß der Heizstempel an seiner der Aussparung (4b) gegenüberliegenden Oberfläche einen Gewindestutzen (2a) mit einer durchgehenden Bohrung aufweist, die in die Aussparung (4b) mündet, und daß der Gewindestutzen (2a) an seinem freien Ende eine Dichtungsfläche aufweist, die mit einer komplementären Dichtungsfläche an dem Heizelement (1) zusammenwirkt, mit dem der Heizstempel (4) verschraubt ist.

3. Entlötgerät nach Anspruch 2, dadurch gekennzeichnet, daß die Dichtungsfläche an dem Heizelement (1) am freien Ende eines in eine Gewindebohrung des Heizelementes (1) eingeschraubten Schraubnippels (3) ausgebildet ist, der eine Schulter (3a) aufweist, über die eine Überwurfmutter (2) greift, die auf den Gewindestutzen (2a) des Heizstempels (4) aufgeschraubt ist.

4. Entlötgerät nach Anspruch 2 oder 3, dadurch gekennzeichnet, daß die Dichtungsflächen konisch sind.

5. Entlötgerät nach Anspruch 3 oder 4, dadurch gekennzeichnet, daß die Gewindebohrung des Heizelementes (1) sich durch dieses hindurcherstreckt und auf der vom Schraubnippel (3) abgewandten Seite mit einem Vakuumschlauch (6) in Verbindung steht.

6. Entlötgerät nach einem der vorhergehenden Ansprüche, ddadurch gekennzeichnet, daß der Saugnapf (5) einen in die Bohrung des Heizstempels (4) und dessen Gewindestutzen (2a) eingesetzten Rohransatz (5a) aufweist, der in der Bohrung einstellbar befestigt ist.

7. Entlötgerät nach einem der Ansprüche 1 - 6, dadurch gekennzeichnet, daß der Saugnapf aus Gummi besteht.

8. Entlötgerät nach einem der Ansprüche 1 bis 6, dadurch gekennzeichnet, daß der Saugnapf aus wärmebeständigem Kunststoff besteht.

9. Entlötgerät nach einem der Ansprüche 1 bis 8, dadurch gekennzeichnet, daß der Heizstempel (4) durch Lot nicht benetzbar ist.

10. Entlötgerät nach einem der Ansprüche 1 bis 8, dadurch gekennzeichnet, daß der Heizstempel (4) durch Lot benetzbar ist.

## Claims

1. Desolderer for electronic components (10) whose terminals are soldered flat onto a support plate (11), comprising a heating punch (4) which is heated by a heating element and has a cutout, and vacuum suction means for sucking the electronic component (10) onto the heating punch, characterized in

that the vacuum suction means (6) include at least one sucker (5) which is disposed in the cutout (4b) and in the operating position of the desolderer is in engagement with the exposed surface of the electronic component (10) whilst the lower edges of the heating punch (4) are placed on the terminals (12) of the electronic component (10).

2. Desolderer according to claim 1, characterized in that the heating punch comprises in its surface opposite the cutout (4b) a threaded tube piece (2a) with a throughbore which opens into the cutout (4b), and that the threaded tube piece (2a) comprises at its free end a sealing face which cooperates with a complementary sealing face on the heating element (1) to which the heating punch (4) is screwed.

3. Desolderer according to claim 2, characterized in that the sealing face on the heating element (1) is formed at the free end of a screw nipple (3) which is screwed into a threaded bore of the heating element (1) and which comprises a shoulder (3a) over which a cap nut (2) engages which is screwed onto the threaded tube piece (2a) of the heating punch (4).

4. Desolderer according to claim 2 or 3, characterized in that the sealing faces are conical.

5. Desolderer according to claim 3 or 4, characterized in that the threaded bore of the heating element (1) extends through the latter and on the side remote from the screw nipple (3) is in connection with a vacuum hose (6).

6. Desolderer according to any one of the preceding claims, characterized in that the sucker (5) comprises a tubular extension (5a) which is inserted into the bore of the heating punch (4) and the threaded tube piece (2a) thereof and is adjustably secured in the bore.

7. Desolderer according to any one of claims 1 to 6, characterized in that the sucker consists of rubber.

8. Desolderer according to any one of claims 1 to 6, characterized in that the sucker consists of heat-resistant plastic.

9. Desolderer according to any one of claims 1 to 8, characterized in that the heating punch (4) is not wettable by solder.

10. Desolderer according to any one of claims 1 to 8, characterized in the heating punch (4) is wettable by solder.

## Revendications

1. Appareil à dessouder des pièces électroniques (10) dont les éléments de fixation sont soudés à plat à une plaque de support (11), appareil à dessouder qui comporte un poinçon chauffant (4), chauffé par un élément chauffant et présentant un creux, ainsi que des organes d'aspiration sous dépression, destinés à l'aspiration de la pièce électronique (10) sur le poinçon chauffant, caractérisé en ce que les organes d'aspiration sous dépression (6) comportent au moins une ventouse (5) qui est prévue dans le creux (4b) du poinçon et qui, lorsque l'appareil à dessouder se trouve dans la position de fonctionnement, est en engagement avec la surface libre de la pièce électronique (10), les faces inférieures des bords d'extrémité du poinçon chauffant (4) ayant été posées sur les éléments de fixation (12) de la pièce électronique (10).

2. Appareil à dessouder suivant la revendication 1, caractérisé en ce que le poinçon chauffant porte, à la face opposée à celle où il présente son creux (4b), une tubulure filetée (2a) formant un passage continu qui débouche dans ce creux (4b), et en ce que la tubulure filetée (2a) présente, à l'extrémité libre, une face d'étanchéité qui coopère avec une face d'étanchéité complémentaire que présente l'élément chauffant (1), auquel le poinçon chauffant (4) est fixé par vissage.

3. Appareil à dessouder suivant la revendication 2, caractérisé en ce que la face d'étanchéité de l'élément chauffant (1) est formée à l'extrémité libre d'un raccord fileté (3) qui est vissé dans un passage taraudé que présente cet élément chauffant (1), raccord fileté qui forme un épaulement (3a) sur lequel est posé un écrou à chapeau (2) qui est vissé sur la tubulure filetée (2a) du poinçon chauffant (4).

4. Appareil à dessouder suivant l'une ou l'autre des revendications 2 et 3, caractérisé en ce que les faces d'étanchéité sont prévues en forme de tronc de cône.

5. Appareil à dessouder suivant l'une ou l'autre des revendications 3 et 4, caractérisé en ce que le passage taraudé que presente l'élément chauffant (1) traverse celui-ci de part en part et, au côté opposé à celui où se trouve le raccord fileté (3), est en communication avec un conduit flexible sous dépression (6).

6. Appareil à dessouder suivant l'une quelconque des revendications précédentes, caractérisé en ce que la ventouse (5) est munie d'une partie tubulaire (5a) qui traverse le passage prévu dans le poinçon chauffant (4) et s'avance dans la tubulure filetée (2a) de celui-ci, partie tubulaire (5a) qui est fixée dans le passage avec possibilité de réglage.

7. Appareil à dessouder suivant l'une quelconque des revendications 1 à 6, caractérisé en ce que la ventouse est faite de caoutchouc.

8. Appareil à dessouder suivant l'une quelconque des revendications 1 à 6, caractérisé en ce que la ventouse est faite de matière synthétique résistant à la chaleur.

9. Appareil à dessouder suivant l'une quelconque des revendications 1 à 8, caractérisé en ce que le poinçon chauffant (4) ne peut pas être garni de soudure.

10. Appareil à dessouder suivant l'une quelconque des revendications 1 à 8, caractérisé en ce que le poinçon chauffant (4) peut être garni de soudure.